# EUROPEAN PATENT SPECIFICATION

(11) **EP 2 966 773 B1**
(45) Date of publication and mention of the grant of the patent: **12.06.2019**
(21) Application number: 14761195.8
(22) Date of filing: 28.02.2014
(51) Int. Cl.: H02S 10/30, H01K 1/04, H01L 31/054

(54) **THERMAL EMISSION SOURCE**
WÄRMESTRAHLUNGSLICHTQUELLE
SOURCE DE LUMIÈRE À RAYONNEMENT THERMIQUE

(30) Priority: 08.03.2013 JP 2013047281
(43) Date of publication of application: 13.01.2016
(73) Proprietor: Japan Science and Technology Agency, Kawaguchi-shi, Saitama 332-0021 (JP)
(72) Inventor: NODA, Susumu, Kyoto-shi Kyoto 615-8510 (JP); SHIBAHARA, Tatsuya, Kyoto-shi Kyoto 615-8510 (JP); DE ZOYSA, Menaka, Kyoto-shi Kyoto 615-8510 (JP); ASANO, Takashi, Kyoto-shi Kyoto 615-8510 (JP); KITANO, Keisuke, Kyoto-shi Kyoto 615-8510 (JP); SUZUKI, Katsuyoshi, Kyoto-shi Kyoto 615-8510 (JP); INOUE, Takuya, Kyoto-shi Kyoto 615-8510 (JP); ISHIZAKI, Kenji, Kyoto-shi Kyoto 615-8510 (JP)
(74) Representative: Cabinet Plasseraud
(86) International application number: PCT/JP2014/055056
(87) International publication number: WO 2014/136671

(56) References cited:
- EP-A1- 2 523 220
- WO-A1-03/019680
- WO-A1-2009/036154
- WO-A1-2012/056806
- WO-A2-2011/146843
- JP-A- 2005 501 383
- US-A1- 2010 104 250
- GREFFET J-J ET AL: "Coherent emission of light by thermal sources", NATURE, NATURE PUBLISHING GROUP, UNITED KINGDOM, vol. 416, no. 6876, 7 March 2002 (2002-03-07), pages 61-64, XP002276869, ISSN: 0028-0836, DOI: 10.1038/416061A
- DAI TAKAGI ET AL: "OS1-1: Evaluation of Prototype Silicon-Photonic Crystal for High- Efficiency Thermophotovoltaic Power Generation System", NATIONAL SYMPOSIUM ON POWER AND ENERGY SYSTEMS; 29-30-06-2006, JAPAN SOCIETY OF MECHANICAL ENGINEERS, JP , vol. 11 28 June 2006 (2006-06-28), pages 21-22, XP008177933, Retrieved from the Internet: URL:http://ci.nii.ac.jp/naid/110006637271/ en
- LEE B ET AL: "Coherent thermal emission from one-dimensional photonic crystals", APPLIED PHYSICS LETTERS, AMERICAN INSTITUTE OF PHYSICS, 2 HUNTINGTON QUADRANGLE, MELVILLE, NY 11747, vol. 87, no. 7, 9 August 2005 (2005-08-09) , pages 71904-071904, XP012077453, ISSN: 0003-6951, DOI: 10.1063/1.2010613
- TATSUYA SHIBAHARA ET AL.: '13a-PA5-8 Kyotaiiki Kinsekigai Si Photonic Kessho Netsufukusha Kogen no Kento' 2012 NEN SHUKI <DAI 73 KAI> EXTENDED ABSTRACTS; THE JAPAN SOCIETY OF APPLIED PHYSICS 27 August 2012, XP008177928
- DE ZOYSA, MENAKA ET AL.: 'Conversion of broadband to narrowband thermal emission through energy recycling' NATURE PHOTONICS vol. 6, August 2012, pages 535 - 539, XP055219891
- HITOSHI SAI ET AL.: 'Shukiteki na Hyomen Bisai Kozo ni yoru Netsufukusha Spectrum no Seigyo' DAI 61 KAI EXTENDED ABSTRACTS; THE JAPAN SOCIETY OF APPLIED PHYSICS vol. 3, 2000, page 909, XP008177939
- DAI TAKAGI ET AL.: 'OS1-1 Evaluation of Prototype Silicon-Photonic Crystal for High- Efficiency Thermophotovoltaic Power Generation System' NATIONAL SYMPOSIUM ON POWER AND ENERGY SYSTEMS 28 June 2006, pages 21 - 22, XP008177933
- TATSUYA SHIBAHARA ET AL.: '28-C1-8 Kinsekigai Si Photonic Kessho Netsufukusha Kogen no Kento (II' 2013 NEN SHUNKI <DAI 60 KAI> EXTENDED ABSTRACTS; THE JAPAN SOCIETY OF APPLIED PHYSICS 11 March 2013, XP008177937
- KOHEI HASHIMOTO ET AL.: '17a-P14-11 Kyotaiiki Kinsekigai Photonic Kessho Netsufukusha Kogen no Kento (III' 2013 NEN SHUKI <DAI 74 KAI> EXTENDED ABSTRACTS; THE JAPAN SOCIETY OF APPLIED PHYSICS 31 August 2013, XP008177930

## Description

### TECHNICAL FIELD

The present invention relates to a thermal emission source that converts heat to light.

### BACKGROUND ART

In general, heating an object causes thermal emission which is a radiation of light (electromagnetic waves) having a spectrum that depends on substances constituting the object and the temperature of the object. Thermal emission generated from an ideal object that completely absorbs light given externally is called a blackbody radiation, and the object is called a blackbody. Blackbody radiation has an intensity distribution over a wide wavelength range, and light having a wavelength spectrum whose distribution is determined only by the temperature is generated. When an ordinary object is heated, it also generates light having a wavelength spectrum distribution over a wide wavelength range; however, it is known that the wavelength spectrum of ordinary object cannot exceed that of a blackbody at a same temperature. Using such thermal emission, light with a spectrum having an intensity distribution over a wide wavelength range is emitted. That is, a light source (thermal emission source) that provides a wide wavelength spectrum can be obtained by a combination of an object and a heat source.

Meanwhile, instead of light having such wide wavelength spectrum, there has also been a demand for a thermal emission source that emits light having a large intensity in a particular wavelength band. Demand of such light source can be found, for example, in the field of solar cells. In solar cells that are currently in practical use, only light in a particular wavelength band in a wide wavelength range of sunlight contributes to photoelectric conversion, and energy of light of other wavelengths is wasted.

Non-Patent Literatures 1 and 2 each describe a thermal emission source including a two-dimensional photonic crystal composed of a plate member having a quantum well structure, which is formed by alternately stacking layers of AlGaAs and layers of GaAs, including a plurality of holes formed on a triangular grid in the plate member. When the plate member is heated, thermal excitation of electrons between energy levels in the quantum well causes emission of light having a plurality of wavelengths corresponding to respective differences between the energy levels, where the wavelength spectrum of the emission of light is narrower than those of common thermal emission sources. The two-dimensional photonic crystal can resonate with light having a predetermined wavelength determined by a periodicity of holes, and selectively intensify the light of that wavelength. The combination of the quantum well and the two-dimensional photonic crystal provides a wavelength spectrum having a narrow bandwidth around the predetermined wavelength and having a large peak intensity.

### CITATION LIST

### PATENT LITERATURE

[Patent Literature 1] WO2005/086302
[Patent Literature 2] WO2007/029661
[Patent Literature 3] JP 2001-074955

### NON PATENT LITERATURE

[Non Patent Literature 1] De Zoysa Menaka et al., "Conversion of broadband to narrowband thermal emission through energy recycling", [online], July 8, 2012, Nature Photonics, [Searched on February 26, 2013], Internet <URL:http://www.nature.com/nphoton/journal/v6/n8/full/nphoton.2012.146.html>
[Non Patent Literature 2] National University Corporation, University of Kyoto, "Success in significantly narrowing thermal emission spectrum from object --- This achieves crucial step toward effective use of energy such as highly-efficient solar cell applications --- ", [online], July 9, 2012, University of Kyoto New Index 2012, [Searched on February 26, 2013], Internet <URL:http://www.kyotou.ac.jp/ja/news_data/h/h1/news6/2012/120709_1.htm 1>

GREFFET J-J ET AL: "Coherent emission of light by thermal sources", NATURE, NATURE PUBLISHING GROUP, UNITED KINGDOM, vol. 416, no. 6876, 7 March 2002 (2002-03-07), pages 61-64, discloses a thermal light-emitting source.

US 2010/104250 A1 discloses a two-dimensional photonic crystal that is used for an optical device such as an optical multiplexer/demultiplexer, or a thermal radiation light source or the like.

DAI TAKAGI ET AL: "OS1-1: Evaluation of Prototype Silicon-Photonic Crystal for High- Efficiency Thermophotovoltaic Power Generation System", NATIONAL SYMPOSIUM ON POWER AND ENERGY SYSTEMS; 29-30-06-2006, JAPAN SOCIETY OF MECHANICAL ENGINEERS, JP, vol. 11 28 June 2006 (2006-06-28), pages 21-22, discloses two-dimensional photonic crystals.

LEE B ET AL: "Coherent thermal emission from one-dimensional photonic crystals", APPLIED PHYSICS LETTERS, AMERICAN INSTITUTE OF PHYSICS, 2 HUNTINGTON QUADRANGLE, MELVILLE, NY 11747, vol. 87, no. 7, 9 August 2005, pages 0719041-0719043, discloses a potential coherent thermal emission source based on a multilayer structure made of a polar material and a ID PC in the half plane.

WO 03/019680 A1 discloses a photonically engineered incandescent emitter, comprising a photonic crystal.

### SUMMARY OF INVENTION

### TECHNICAL PROBLEM

In the thermal emission sources described in Non-Patent Literatures 1 and 2, the peak wavelength of the wavelength spectrum is approximately 10 µm, while the wavelength band contributing to photoelectric conversion in a solar cell is around 1.0 µm if the solar cell is of a generally-used silicon type, and is around 1.5 µm if the solar cell is of a silicon-germanium type. Also, a quantum well structure requires use of two kinds of materials that have respective bandgaps largely different from each other, and thus, as long as a quantum well structure is used, it is difficult to set a peak wavelength to a desired value because combinations of available materials are limited. Therefore, in the thermal emission sources described in Non-Patent Literatures 1 and 2, the ratio of light contributing to photoelectric conversion in a solar cell cannot be increased, resulting in failure to achieve photovoltaic power generation with high photoelectric conversion efficiency.

The aforementioned problem of the difficulty in arbitrarily setting the peak wavelength is not specific to thermal emission sources that are used in combination with solar cells, but arises in various uses.

An object of the present invention is to provide a thermal emission source that allows a wide range of material choices so that light having a desired peak wavelength can easily be obtained. The present invention also provides a photovoltaic device using the thermal emission source and having high photoelectric conversion efficiency.

### SOLUTION TO PROBLEM

In order to attain the aforementioned object, a thermal emission source according to the present invention includes the features of claim 1.

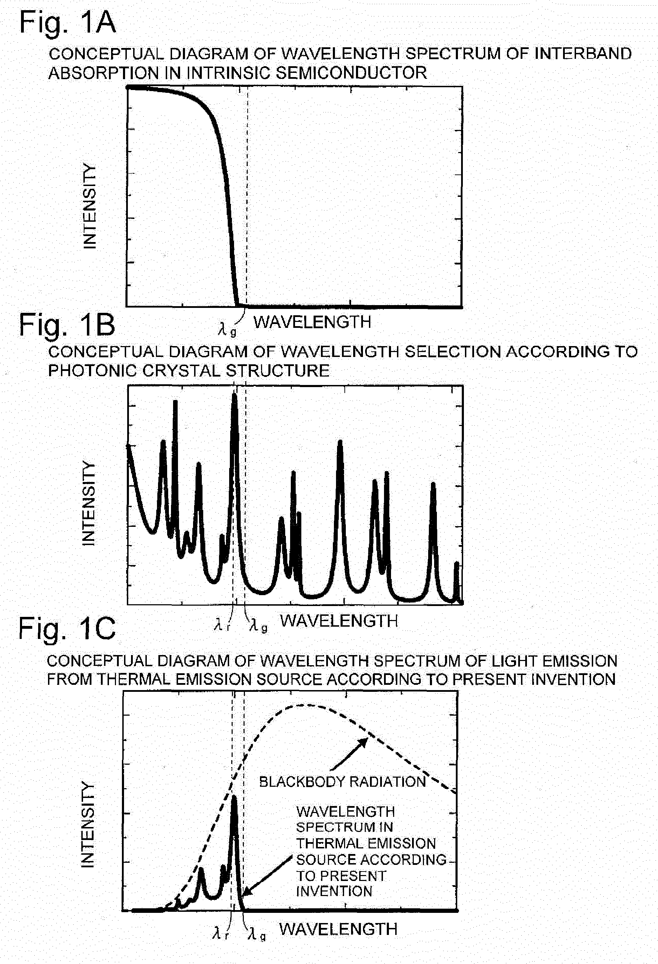

In the thermal emission source according to the present invention, when heat is externally supplied to the thermo-optical converter, energy is absorbed by the intrinsic semiconductor, causing thermal excitation of electrons from the valance band to the conduction band across the bandgap. Such absorption is called "interband absorption". Then, as a result of the transition of the excited electrons to the valance band across the bandgap, light is produced. The light has higher energy than that of the bandgap and thus has wavelengths that are shorter than a wavelength λ_{g} = hc/E_{g} (h is the Planck's constant and c is the speed of light) corresponding to the energy E_{g} of the bandgap. Therefore, the wavelength spectrum of the light generated by the intrinsic semiconductor because of the interband absorption is within a band of wavelengths that are shorter than the wavelength λ_{g} (Fig. 1A). Hereinafter, the wavelength λ_{g} is referred as "cutoff wavelength".

Then, among the light generated by the interband absorption as stated above, light of wavelengths around a wavelength that causes resonance in the optical structure (hereinafter referred to as "resonant wavelength λᵣ"; Fig. 1B) is selectively intensified and emitted to the outside of the thermo-optical converter (Fig. 1C). An example of the optical structure is a photonic crystal structure. In the photonic crystal structure, a periodic refractive index distribution is formed, and light of a wavelength λᵣ corresponding to the period forms standing waves. Such a photonic crystal structure that allows formation of standing waves of the resonant wavelength λᵣ can be created by a person skilled in the art according to, for example, the disclosure of Patent literatures 1 and 2. Also, another example of the optical structure includes one in which a plurality of members having a larger refractive index than that of a base is arranged on the base, which will be described later. In this example, in each member, standing waves formed by light of the wavelength λᵣ determined by the size of the member are formed.

According to the aforementioned principle, the thermal emission source according to the present invention produces thermal emission having a resonant wavelength λᵣ as the peak wavelength and having a wavelength spectrum having a narrower width than that of the spectrum of the thermal emission.

In the optical structure, not only light of the resonant wavelength λᵣ is generated, but also resonance (higher-order resonance) may occur on the wavelength shorter than the resonant wavelength λᵣ. However, the maximal value of intensity of thermal emission is restricted to the intensity of the blackbody radiation spectrum, and the intensity of the blackbody radiation spectrum sharply decreases on the short wavelength side. Thus, light emission due to higher-order resonance can sufficiently be suppressed.

The width of the bandgap of the intrinsic semiconductor changes depending on the temperature. The resonant wavelength in the thermo-optical converter is determined by the configuration of the optical structure and thus does not directly depend on the temperature. However, the refractive index changes according to the temperature, and along with the change in the refractive index, the light speed changes. Therefore, the resonant wavelength changes depending on the temperature. Thus, the cutoff wavelength λ_{g} and the resonant wavelength λᵣ may be determined based on the width of the bandgap and the refractive index of the intrinsic semiconductor at the heating temperature when the thermal emission source according to the present invention is used.

The present invention uses an intrinsic semiconductor and allows a wider range of material choices compared to a case where a quantum well structure obtained by combination of two types of semiconductors is used. Thus, a thermal emission source that produces light of an intended wavelength can easily be obtained. For the intrinsic semiconductor, any of various materials such as Si (silicon), SiC (silicon carbide) and Cu₂O (copper oxide (I)) can be used. The cutoff wavelength λ_{g} is approximately 1700 nm (1400 K) in the case of Si, approximately 800 nm (2200 K) in the case of 3C-SiC (SiC having a cubic structure called "3C" from among SiCs), and is approximately 900 nm (1200 K) in the case of Cu₂O. The cutoff wavelength λ_{g} described here is the value at the temperature indicated in each following bracket, and each of these temperatures is an example which may be used in the thermal emission source, which is determined in consideration of a melting point of each intrinsic semiconductor (Si: 1687K, 3C-SiC: 3100K or Cu₂O: 1505K).

If the resonant wavelength λᵣ is too close to the cutoff wavelength λ_{g}, the portion on the long wavelength side of the wavelength spectrum of the thermal emission is cut off. Thus it is desirable that the resonant wavelength λᵣ be shorter than the cutoff wavelength λ_{g} to some extent. For example, it is desirable that the resonant wavelength λᵣ be 1600 nm (temperature: 1400 K) or shorter if the intrinsic semiconductor is Si, approximately 750 nm (2200 K) or shorter if the intrinsic semiconductor is 3C-SiC and approximately 850 nm (1200 K) or shorter if the intrinsic semiconductor is Cu₂O.

It is desirable that the optical structure be asymmetric with respect to the direction in which thermal emission is emitted from the thermal emission source. If the optical structure has no such asymmetry (that is, if the optical structure is symmetric in the direction), thermal emission is emitted both in the direction and in the direction opposite to the direction with the same intensity. If the optical structure has such asymmetry, thermal emission is emitted in one direction with a larger intensity.

An example of the optical structure is a two-dimensional photonic crystal structure formed by periodically providing, in a plate member composed of an intrinsic semiconductor, areas each having a refractive index that is different from that of the plate member (different refractive index area). For each of the different refractive index areas, a hole (air or vacuum) can be used, or a member composed of a material that is different from the intrinsic semiconductor can be used. In this example, standing waves of a wavelength determined by the length of periodicity of the different refractive index areas are formed in the thermo-optical converter. Also, it is desirable that in the photonic crystal structure of this example, the different refractive index areas be asymmetric with respect to the direction perpendicular to the plate member. Consequently, thermal emission can be emitted to one surface of the plate member with a larger intensity. Examples of the different refractive index areas having such asymmetry includes those having a triangular or trapezoidal shape in the cross-section perpendicular to the plate member; however, different refractive index areas that open in one surface of the plate member and do not open in the other surface of the plate member are desirable in terms of easy fabrication.

For the optical structure, it is desirable to use such a structure that, on a surface of a base made of material having a refractive index lower than that of the intrinsic semiconductor, members (high-refractive index members) made of the intrinsic semiconductor and having the same shape are two-dimensionally arranged. The arrangement of the high-refractive index members does not need to be periodic. Such configuration allows formation of standing waves of a wavelength corresponding to the size of the high-refractive index members within each high-refractive index member. Therefore, the high-refractive index member itself can be made to function as an optical resonator (high-refractive index member optical resonator), enabling light whose wavelength of the standing waves is resonant wavelength to be selectively amplified. Since the optical structure is asymmetric as stated above, thermal emission can be emitted in one direction with a larger intensity.

For the optical structure, a three-dimensional photonic crystal structure having a three-dimensional periodic refractive index distribution may be used. In the three-dimensional photonic crystal structure, a wavelength band in which light cannot exist within the structure can be formed irrespective of the direction of polarization of light. Such a wavelength band is formed for light for the reason similar to the bandgap for electrons, and is called "photonic bandgap" to distinguish from the bandgap for electrons. In the present invention, use of a three-dimensional photonic crystal structure enables selectively amplifying light of a predetermined wavelength that causes resonance in the three-dimensional photonic crystal structure (that is, light of a wavelength that can exist in the three-dimensional photonic crystal structure) while preventing production of light of wavelengths in the photonic bandgap, whereby light of the predetermined wavelength can efficiently be produced.

Combining the thermal emission source according to the present invention with a solar cell, a highly-efficient photovoltaic device can be obtained. In other words, the photovoltaic device includes a thermo-optical converter according to the present invention, and a solar cell for performing photoelectric conversion by receiving light produced by the thermo-optical converter and using the light having a wavelength band including the resonant wavelength.

In the photovoltaic device according to the present invention, the solar cell receives light with the wavelength spectrum having a narrower width (but capable of making photoelectric conversion) than that of the wavelength spectrum of sunlight and including the resonant wavelength from the thermo-optical converter, the intensity of light having the wavelength band that makes photoelectric conversion is enhanced compared to a case where the solar cell directly receives sunlight. Thus, the photoelectric conversion efficiency is enhanced compared to a case where the solar cell directly receives sunlight. For example, a silicon solar cell cannot perform photoelectric conversion at wavelengths about 1000 nm or longer, and thus it is desirable to set the resonant wavelength λᵣ of the thermo-optical converter at 1000 nm or shorter.

### ADVANTAGEOUS EFFECTS OF INVENTION

The present invention enables use of an intrinsic semiconductor that allows a wider range of material choices, enabling easy provision of a thermal emission source that produces narrow-band light having a desired peak wavelength.

The present invention also enables provision of a photovoltaic device having a higher photoelectric conversion efficiency than that in a case where a solar cell directly receives sunlight.

### BRIEF DESCRIPTION OF DRAWINGS

Fig. 1A, Fig. 1B and Fig. 1C are diagrams for describing a reason that light having a particular wavelength band is produced in a thermal emission source according to the present invention, and Fig. 1A is a conceptual diagram of a wavelength spectrum of interband absorption in an intrinsic semiconductor, Fig. 1B is a conceptual diagram of wavelength selection according to an optical structure, and Fig. 1C is a conceptual diagram of a wavelength spectrum of light emission by the thermal emission source according to the present invention.
Fig. 2 is a perspective diagram illustrating a thermal emission source according to a first embodiment.
Fig. 3 is a plan view of the thermal emission source according to the first embodiment.
Fig. 4 is a graph showing an example of a wavelength spectrum obtained, by calculation, by the thermal emission source according to the first embodiment.
Fig. 5 is a schematic configuration diagram illustrating an example of a photovoltaic device using the thermal emission source according to the first embodiment.
Fig. 6A and Fig. 6B are an optical photomicrograph and an electron photomicrograph respectively taken of the thermal emission source produced in the first embodiment.
Fig. 7 is a graph showing a result of measurement of a wavelength spectrum obtained by the thermal emission source produced in the first embodiment.
Fig. 8 is a perspective view of a thermal emission source according to a second embodiment which is comparative and does not form part of the present invention.
Fig. 9A is a top view of the thermal emission source of the second embodiment, Fig. 9B is a cross-sectional view along plane A-A, and Fig. 9C is a cross-sectional view along plane B-B.
Fig. 10 is a graph showing an example of a wavelength spectrum obtained, by calculation, by the thermal emission source according to the second embodiment.
Fig. 11 is a perspective diagram illustrating an alteration of the thermal emission source according to the second embodiment.
Fig. 12 is a perspective diagram illustrating a thermal emission source according to a third embodiment which is comparative and does not form part of the present invention.
Fig. 13 is a graph showing differences in absorptance among plate members having different thicknesses.

### DESCRIPTION OF EMBODIMENTS

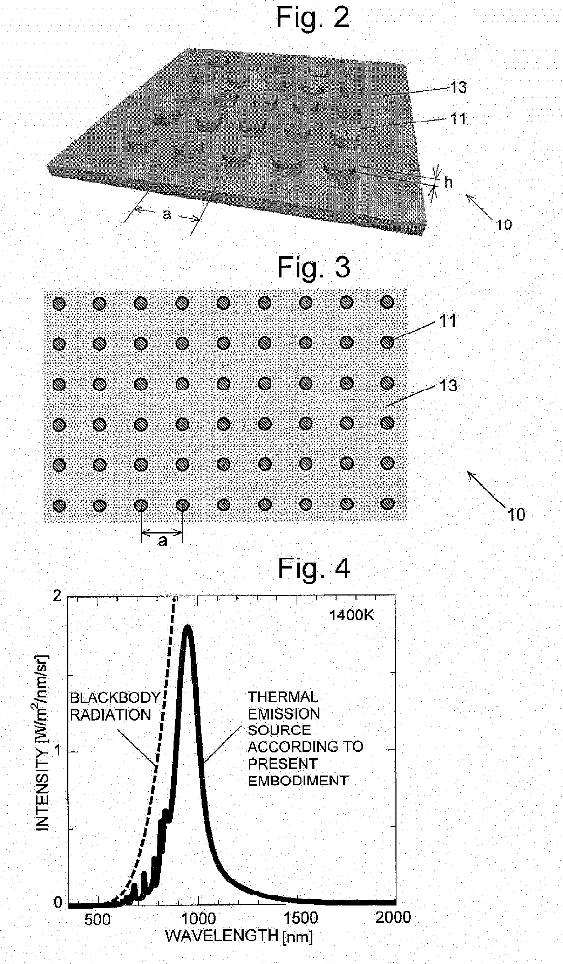

Embodiments of a thermal emission source according to the present invention will be described with reference to Fig. 2 to Fig. 13.

### [Embodiment 1]

As illustrated in Fig. 2 and Fig. 3, a thermal emission source 10 according to a first embodiment has an optical structure in which a plurality of columnar rods 11 made of an intrinsic semiconductor is arranged on a surface of a base 13 having a lower refractive index than that of the intrinsic semiconductor. In the present embodiment, for a material of the rod 11, Si (refractive index: 3.4) is used, and for a material of the base 13, SiO₂ (refractive index: 1.5) is used. A radius r of the rods 11 is 100 nm and a height h of the rods is 500 nm. In the present embodiment, the rods 11 are arranged at grid points of a square grid whose period length "a" is 600 nm; however, such periodic arrangement of the rods 11 is not essential to the present invention.

From among the above parameters, a resonant wavelength λᵣ in the optical structure in the present embodiment is determined by the refractive index n and the radius r of the rods 11 and the period length "a" of the square grid as described below.

In the thermo-optical converter, light propagates in a height direction of the rods 11 along the rods 11 having a higher refractive index than that of the surrounding areas. Then, the light is reflected by an upper end and a lower end of each rod 11, whereby standing waves are generated and a resonant state of the light is formed. The resonant wavelength λᵣ depends on the height h of the rods 11 and also depends on the radius r of the rods 11 since the effective refractive index varies when the light leaks from the rods 11. A difference in period length "a" of the rods 11 affects the resonant wavelength λᵣ in terms of a difference in effective refractive index, but not so largely as a difference in radius r of the rods 11 does. The rods 11 having an excessively short period length "a" causes the wide range of electromagnetic field overlapped distribution among the rods 11 and interaction thereby occurs, resulting in variation in the resonant wavelength depending on the emission angle of the light. On the other hand, the period length "a" having a longer period length than that of a light emission wavelength invokes high-order diffraction, whereby radiation in one resonant mode is generated in a plurality of directions. Therefore, it is desirable that the period length "a" be longer than a distance of oozing of an electromagnetic field from each rod and be shorter than the light emission wavelength.

In the present embodiment, the radius r of the rods 11 is set to 100 nm and the height h of the rods is set to 500 nm, whereby the wavelength λᵣ of a resonant mode generated in each rod becomes 950 nm. Furthermore, the period length "a" is set to 600 nm, which is shorter than the resonant wavelength λᵣ and sufficiently larger than the rod radius, whereby emission angle dependency is suppressed while the light emission intensity is maintained.

A principle of heat to light conversion by the thermal emission source 10 according to the first embodiment will be described. When the thermal emission source 10 is heated to a temperature of around 1400 K, energy absorption caused by interband absorption in Si, which is an intrinsic semiconductor on the wavelength shorter than a cutoff wavelength λ_{g} for Si ≈ 1700 nm (on the high energy side that is higher than 0.73 eV, which is photon energy corresponding to the cutoff wavelength λ_{g}) occurs, and light emission corresponding to the energy occurs on the wavelength shorter than the cutoff wavelength λ_{g} (high energy side). A spectrum of the light generated as above, as indicated in Fig. 1A, continues on the wavelength shorter than λ_{g}, and in such continuous wavelength band, a wavelength spectrum with around a resonant wavelength λᵣ≈ 950 nm as a maximal value (peak top) can be obtained by the optical structure according to the present embodiment.

An example of a wavelength spectrum that can be obtained, by calculation, by the thermal emission source 10 according to the first embodiment is indicated in Fig. 4. In this example, the calculation is performed for a case where the thermal emission source 10 is heated to 1400 K (1127°C). As indicated in the figure, the wavelength spectrum has a single peak with a wavelength of approximately 950 nm as a peak top. The cutoff wavelength λ_{g} of Si is approximately 1700 nm (the corresponding photon energy is approximately 0.73 eV), and almost no light emission occurs on the wavelength longer than the cutoff wavelength λ_{g}. Also, on the low wavelength side relative to the peak, the spectrum of blackbody radiation becomes smaller as the wavelength is shorter, and the wavelength spectrum of the thermal emission source 10 becomes smaller accordingly as the wavelength is shorter.

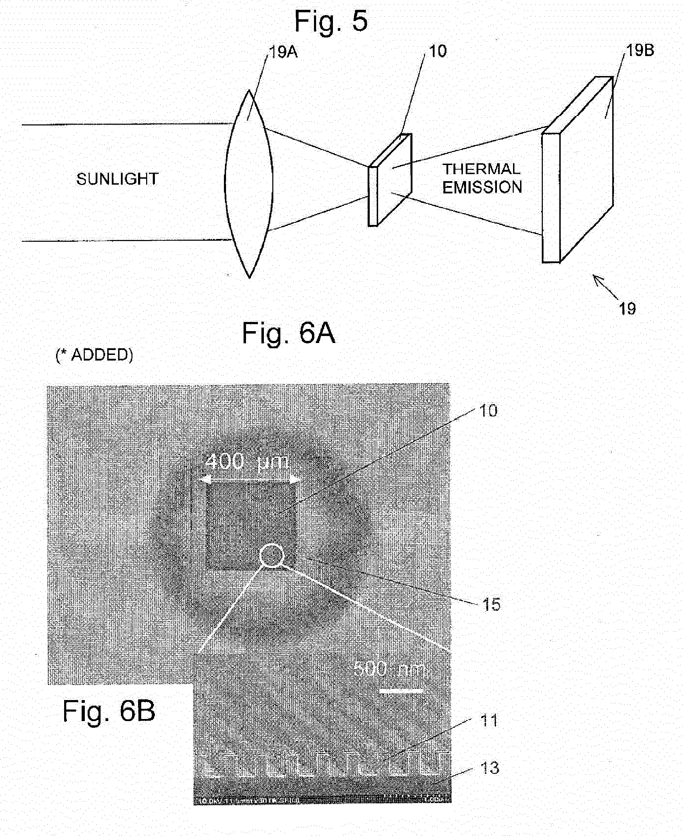

As described above, the thermal emission source 10 according to the present embodiment can selectively emit only wavelengths that are around the resonant wavelength λᵣ = 950 nm. A silicon solar cell cannot perform photoelectric conversion of light of wavelengths exceeding approximately 1000 nm. Therefore, as illustrated in Fig. 5, a photovoltaic device 19 can be constructed by the thermal emission source 10, a collective lens 19A that collects sunlight to the thermal emission source 10, and a silicon solar cell 19B that receives thermal emission from the thermal emission source 10. Consequently, photoelectric conversion can be performed in the silicon solar cell 19B after conversion of sunlight having a wide wavelength spectrum including light of wavelengths exceeding approximately 1000 nm to light having a peak of a wavelength spectrum at a wavelength of 1000 nm or shorter (950 nm in the present embodiment) by the thermal emission source 10, enabling enhancement in efficiency of the photoelectric conversion.

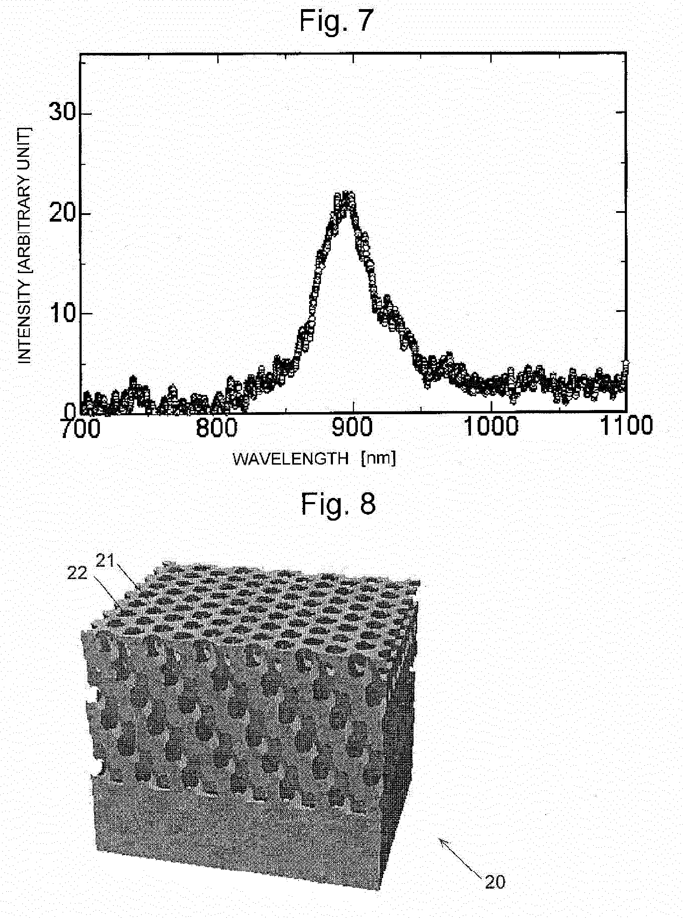

Next, a result of measurement using an actually-produced thermal emission source 10 will be described with reference to Fig. 6A, Fig. 6B and Fig. 7. Fig. 6A is an optical photomicrograph taken of the produced thermal emission source 10, and Fig. 6B is a magnified electron photomicrograph taken of the rods 11 and the base 13 of the thermal emission source 10. In the produced thermal emission source 10, columnar rods 11 made of Si are arranged in a square grid in a square area 400 µm on a side on a surface of a plate base 13 made of SiO₂ and has a thickness of approximately 3 µm. A radius r of the rods 11 is 100 nm, a height h is 450 nm, and a periodic length "a" of the square grid is 500 nm. Also, a plate heater 15 having a three-layer structure constructed of a layer of Ti, a layer of Pt and a layer of Ti in this order from the side close to the base 13 is provided, so as to be contact with a lower surface of the base 13 (surface on the opposite side of the surface on which the rods are provided). When current was flown to the heater 15, the thermal emission source 10 was heated to a temperature of approximately 500 K, and the heat was converted to light according to the above-described principle, whereby light emission was obtained. When a spectrum of the obtained light emission was measured, as shown in Fig. 7, a wavelength spectrum having a peak at a wavelength of approximately 900 nm was obtained.

Although an example in which Si is used for the material of the rods 11 has been described up to here, an intrinsic semiconductor other than Si such as SiC or Cu₂O may be used. If 3C-SiC is used for the material of the rods 11, the cutoff wavelength λ_{g} is 800 nm, which is shorter than that in the case of Si, and thus, the height and the radius of the rods 11 is set to be small compared to those in the case of Si. This obtains a thermal emission source that produces thermal emission having a wavelength spectrum with a peak on the wavelength shorter than 750 nm. A thermal emission source having such characteristics as above can suitably be used as a light source that emits thermal emission resulting from conversion of sunlight to a GaAs solar cell.

Also, although in the first embodiment, the rods 11 are arranged in a square grid, arrangement in, e.g., a triangular grid may be employed. Also, although the shape of the rods 11 is a columnar shape, a shape such as a square rod, and in comparative embodiments a cone or a pyramid may be employed. Furthermore, the surrounding areas of the rods 11 may be filled with a material having a lower refractive index than that of the rods 11, such as SiO₂.

### [Embodiment 2]

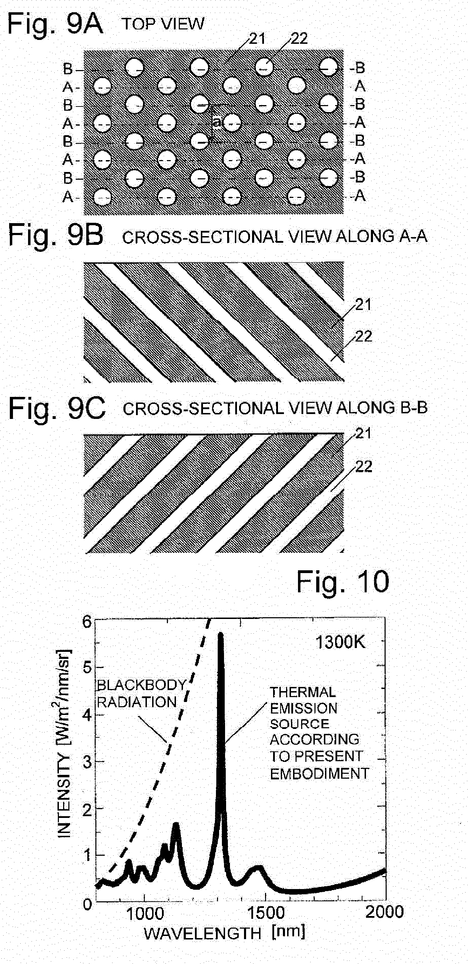

As illustrated in Fig. 8 and Fig. 9, a thermal emission source 20 according to a second embodiment which is comparative and does not form part of the present invention has a structure in which columnar holes 22 each extending in a direction inclined by 45° from the normal to an upper surface of a block- member 21 composed of an intrinsic semiconductor are periodically formed. The columnar holes 22 are arranged in a triangular grid with a period length "a" in the upper surface of the block member 21. Also, directions in which the columnar holes 22 in adjacent rows with grid points in the triangular grid extend are different by 90° from each other (alternation of the cross-sections along A-A and the cross-sections along B-B in Fig. 9A) (Fig. 9A and Fig. 9C). Such configuration allows formation of a three-dimensional photonic crystal structure having a three-dimensional periodic refractive index distribution in a blockd member 21 composed of an intrinsic semiconductor (optical structure in the present embodiment). In the present embodiment, a material of the block member 21 is Si, and a period length "a" is 680 nm.

An example of a wavelength spectrum obtained by the thermal emission source 20 according to the second embodiment is indicated in Fig. 10. In this example, a wavelength spectrum if the thermal emission source 20 is heated to 1300 K (1027°C) was obtained by calculation. As illustrated in the figure, a wavelength spectrum with a wavelength of approximately 1300 nm as a peak top was obtained.

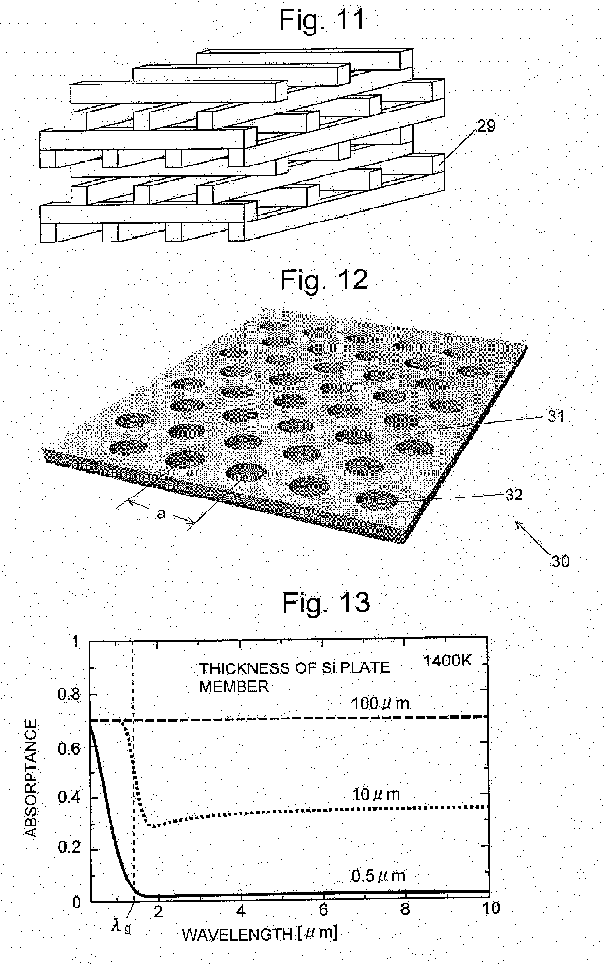

The material of the block member 21 is not limited to Si mentioned above and, e.g., SiC or Cu₂O may be used. Also, instead of the columnar holes 22, members having a lower refractive index than that of the block member 21 may be used. Alternatively, as illustrated in Fig. 11, a three-dimensional photonic crystal in which layers having rod members 29 each composed of an intrinsic semiconductor and arranged in parallel are stacked may be used, where a direction of the rod members in a layer is different by 90° from that of the rod members in a longitudinally adjacent layer (see Patent Literature 3).

### [Embodiment 3]

As illustrated in Fig. 12, a thermal emission source 30 according to a third embodiment which is comparative and does not form part of the present invention has a configuration in which holes (different-refractive index areas) 32 is periodically provided in a plate member 31, whereby a two-dimensional photonic crystal structure (optical structure in the present embodiment) is formed. For a material of the plate member 31, in the present embodiment, Si (refractive index: 3.4) is used. The holes 32 are arranged in a triangular grid. A planar shape of the individual holes 32 is a round shape. In this configuration, in the thermal emission source 30 according to the present embodiment, holes 32 each having a refractive index of approximately 1 are periodically arranged in the Si plate member 31 made of an intrinsic semiconductor and has the refractive index of 3.4, whereby a two-dimensional periodic refractive index distribution is formed.

In the present embodiment, a period length "a" of the holes 32 is set to 600 nm. Also, a radius of the holes 32 is set to 150 nm. Also, the plate member 31 has a thickness of 500 nm, and the holes 32 are formed to have a depth of 200 nm from one surface of the plate member 31. The holes 32 are provided so as to form openings in one surface of the plate-like member 31 and not form the openings in the other surface, which forms asymmetry in a direction perpendicular to the plate member 31. Thus, thermal emission can be emitted with a larger intensity from the surface of the plate member 31 through which the holes 32 extend. In the present embodiment, as a diameter of the holes 32 is larger, an average refractive index in a case of combining the plate member 31 and the holes 32 is smaller, and thus, if the period length "a" remains constant, as the diameter is larger, the wavelengths in air is shorter.

In the present embodiment, only light of wavelengths close to a resonant wavelength λᵣ= 1600 nm on the wavelength shorter than a cutoff wavelength λ_{g}≈ 1700 nm is selected and amplified and emitted to the outside.

The thickness of the plate-like member 31 can be changed within a certain range while the resonant wavelength is maintained to be similar, by adjusting, e.g., the diameter, depth or periodicity of the holes. However, excessive increase in the thickness causes energy absorption by intrinsic carriers in the intrinsic semiconductor, which may result in undesired light emission on the wavelength longer than the cutoff wavelength λ_{g}. As an example, each energy absorptance of a Si plate member having a thickness of 0.5 µm (500 nm), which is the same as that of the present embodiment, and Si plate members having a thickness of 10 µm and 100 µm, respectively, when the members are heated to 1400 K (1127°C) was obtained by calculation. As shown in Fig. 13, on the longer wavelength side than the cutoff wavelength λ_{g} for Si ≈ 1700 nm (corresponding photon energy: 0.73 eV), the absorptance has a value of almost 0.7 where the thickness of the plate member is 100 µm, and the absorptance has a value of 0.30 to 0.35 where the thickness is 10 µm, whereas the absorptance has a value of almost zero where the thickness is 0.5 µm. This means that as the thickness of the plate member is larger, undesired light emission on the long wavelength side occurs with larger intensity. Therefore, in order to suppress such light emission, it is desirable that the thickness of the plate member 31 be thin. However, if the thickness of the plate member 31 is extremely small, light emission having the resonant wavelength also decreases, and thus, it is desirable to select a proper thickness in view of this point. In the present embodiment, 0.5 µm is optimum.

Such unnecessary light emission on the long wavelength side may occur in the first and second embodiments. In the first embodiment, an effective thickness of intrinsic semiconductor averaged in a direction parallel to a surface of the base 13 can be changed by changing the height or diameter of the rods 11 made of the intrinsic semiconductor, enabling adjustment so that light emission on the long wavelength side is suppressed. In the second embodiment, the periodicity of the columnar holes 22 or the rod members 29 is adjusted so that a three-dimensional photonic bandgap is formed on the wavelength longer than the resonant wavelength, whereby light on the longer wavelength cannot exist in the three-dimensional photonic crystal structure. Therefore, production of the light is thus suppressed.

Although an example in which Si is used for the material of the plate member 31 has been described up to here, an intrinsic semiconductor other than Si such as SiC or Cu₂O may be used. Also, although an example in which the holes 32 are arranged in a triangular grid has been described up to here, arrangement in, e.g., a square gird may be employed. Although a planar shape of the holes 32 is a round shape, a planar shape other than a round shape such as a regular triangle shape may be employed. Furthermore, instead of the holes 32, members having a lower refractive index than that of the material of the plate member 31 such as members made of SiO₂ may be provided.

### REFERENCE SIGNS LIST

- 10, 20, 30 ...: Thermal emission source
- 11 ...: Rod
- 13 ...: Base
- 15 ...: Heater
- 19 ...: Photovoltaic Device
- 19A ...: Collective Lens
- 19B ...: Silicon Solar Cell
- 21 ...: Block Member
- 22 ...: Columnar Hole
- 29 ...: Rod Member
- 31 ...: Plate Member
- 32 ...: Hole

## Claims

1. A thermal emission source (10) comprising a thermo-optical converter having an optical structure in which a refractive index distribution is formed in a member composed of an intrinsic semiconductor wherein the optical structure has such a structure that, on a surface of a base (13) made of material having a refractive index lower than that of the intrinsic semiconductor, members composed of the intrinsic semiconductor are two-dimensionally arranged, wherein the members are rods (11), and wherein the intrinsic semiconductor is configured to resonate with light of a shorter wavelength than a wavelength corresponding to a bandgap of the intrinsic semiconductor by reflection from an upper end and a lower end of each rod (11).

2. The thermal emission source according to claim 1, wherein the intrinsic semiconductor is Si, and the wavelength for the resonance is 1000 nm or shorter.

3. The thermal emission source according to any of claims 1 to 2, wherein the intrinsic semiconductor is 3C-SiC, and the wavelength for the resonance is 750 nm or shorter.

4. A photovoltaic device comprising the thermal emission source according to any of claims 1 to 3, and a solar cell for performing photoelectric conversion by receiving light produced by the thermo-optical converter and using the light having a wavelength band including the wavelength for the resonance.

## Patentansprüche

1. Wärmestrahlungslichtquelle (10) mit einem thermooptischen Wandler mit einer optischen Struktur, bei der eine Brechungsindexverteilung in einem Element gebildet ist, das aus einem intrinsischen Halbleiter ausgebildet ist, wobei die optische Struktur eine derartige Struktur hat, dass auf einer Fläche einer Basis (13), die aus einem Material besteht, dessen Brechungsindex niedriger als der des intrinsischen Halbleiters ist, aus dem intrinsischen Halbleiter ausgebildete Elemente zweidimensional angeordnet sind, wobei die Elemente Stäbe (11) sind und wobei der intrinsische Halbleiter so ausgebildet ist, dass er durch Reflexion von einem oberen Ende und einem unteren Ende jedes Stabs (11) mit Licht schwingt, das eine kürzere Wellenlänge als eine einer Bandlücke des intrinsischen Halbleiters entsprechenden Wellenlänge hat.

2. Wärmestrahlungslichtquelle nach Anspruch 1, wobei der intrinsische Halbleiter Si ist und die Wellenlänge für die Resonanz 1000 nm oder kürzer ist.

3. Wärmestrahlungslichtquelle nach einem der Ansprüche 1 und 2, wobei der intrinsische Halbleiter 3C-SiC ist und die Wellenlänge für die Resonanz 750 nm oder kürzer ist.

4. Photovoltaische Vorrichtung mit der Wärmestrahlungslichtquelle nach einem der Ansprüche 1 bis 3 und einer Solarzelle zum Durchführen einer photoelektrischen Umwandlung durch Empfangen von vom thermooptischen Wandler erzeugtem Licht und Verwenden des Lichts, das ein Wellenlängenband einschließlich der Wellenlänge für die Resonanz hat.

## Revendications

1. Source d'émission thermique (10) comprenant un convertisseur thermooptique comportant une structure optique dans laquelle une répartition d'indice de réfraction est formée dans un organe composé d'un semi-conducteur intrinsèque, dans laquelle la structure optique comporte une structure telle que, sur une surface d'une base (13) constituée d'un matériau ayant un indice de réfraction inférieur à celui du semi-conducteur intrinsèque, des organes composés du semi-conducteur intrinsèque sont agencés de manière bidimensionnelle, dans laquelle les organes sont des tiges (11), et dans laquelle le semi-conducteur intrinsèque est configuré pour résonner avec une lumière d'une longueur d'onde plus courte qu'une longueur d'onde correspondant à une bande interdite du semi-conducteur intrinsèque par réflexion à partir d'une extrémité supérieure et d'une extrémité inférieure de chaque tige (11).

2. Source d'émission thermique selon la revendication 1, dans laquelle le semi-conducteur intrinsèque est Si, et la longueur d'onde pour la résonance est inférieure ou égale à 1000 nm.

3. Source d'émission thermique selon la revendication 1 ou 2, dans laquelle le semi-conducteur intrinsèque est 3C-SiC, et la longueur d'onde pour la résonance est inférieure ou égale à 750 nm.

4. Dispositif photovoltaïque comprenant la source d'émission thermique selon l'une quelconque des revendications 1 à 3, et une cellule solaire pour effectuer une conversion photoélectrique par la réception d'une lumière produite par le convertisseur thermooptique et l'utilisation de la lumière ayant une bande de longueurs d'onde incluant la longueur d'onde pour la résonance.
